(19) Europäisches Patentamt
European Patent Office
Office européen des brevets

(11) EP 1 120 791 A1

(12) EUROPEAN PATENT APPLICATION
published in accordance with Art. 158(3) EPC

(43) Date of publication:
01.08.2001 Bulletin 2001/31

(51) Int Cl.7: G11C 11/40, G11C 16/04,
H01L 27/108

(21) Application number: 99969937.4

(22) Date of filing: 29.09.1999

(86) International application number:
PCT/JP99/05338

(87) International publication number:
WO 00/21092 (13.04.2000 Gazette 2000/15)

(84) Designated Contracting States:
AT BE CH CY DE DK ES FI FR GB GR IE IT LI LU
MC NL PT SE

(30) Priority: 02.10.1998 JP 28066398

(71) Applicants:
• Hitachi, Ltd.
Chiyoda-ku, Tokyo 101-8010 (JP)
• HITACHI EUROPE LIMITED
Maidenhead, Berkshire, SL6 8YA (GB)

(72) Inventors:
• ITO, Kiyoo Ctr. Res. Lab., Hitachi, Ltd.
Kokubunji-shi Tokyo 185-8601 (JP)
• NAKAZATO, Kazuo Hitachi Europe Limited
Madingley Road Cambridge CB3 0HE (GB)

(74) Representative: Beetz & Partner Patentanwälte
Steinsdorfstrasse 10
80538 München (DE)

(54) SEMICONDUCTOR DEVICE

(57) [Object] A conventional large capacity DRAM (dynamic random access memory) tends to become unstable in operation because of the low read signal voltage of the memory cell. If the memory cell is provided with a gain to raise the signal voltage, then the memory cell area will increase. Therefore a memory cell stable in operation, small in area and capable of RAM operation is called for.

[Constitution] For instance, an MOS transistor for holding an information voltage, a write transistor for providing the information voltage (e.g. a tunnel transistor) and a capacitor for controlling the gate voltage may be three-dimensionally structured into a memory cell. [Effect] An inexpensive semiconductor capable of fast and stable operation can be realized. Furthermore, even a nonvolatile RAM function can be added.

## FIG. 1

**Description**

[Industrial Field of Utilization]

The present invention relates to a highly reliable large capacity semiconductor memory apparatus.

[Prior Art]

Semiconductor memories can be broadly classified into RAMs (random access memories) and ROMS (read only memories). Of them, the type used in the greatest quantity as main memories for computers is the dynamic RAM (DRAM). A memory cell for storing information comprising a capacitor and a read transistor for reading electric charges stored. therein. This memory, as it is realized with a smallest number of constituent elements as a RAM, is suitable for use on a large scale. Accordingly, it has been mass produced at a relatively low cost. A problem with DRAMs, however, is that their operation is susceptible to instability. The greatest destabilizing factor is that the memory cell itself has no amplifying capability, and therefore the voltage of signals read out of the memory cell is low, making the operation of the memory cell sensitive to various kinds of noise. Furthermore, the information charge stored in the capacitor is extinguished by a pn junction (leak) current existing in the memory cell. Therefore, the stored information is conserved by causing the memory cell to refresh itself (undergo rewriting) periodically before the information disappears. This period, known as refreshing time, is about 100 ms at present, but it will have to be increasingly elongated with an increase in storage capacity. Thus it is necessary to suppress the leak current, but this is becoming more and more difficult as elements become finer. Memories to solve this problem are ROMs, especially flush memories. A flush memory, as is well known, is as small as a DRAM cell or even smaller, and its signal voltage is high because it has a gain in the memory cell, resulting in stable operation. Moreover, as it stores memory charges in a storage node surrounded by an insulating film, it is free from a pn junction current unlike a DRAM, and accordingly needs no refreshing. However, the storage node, because it flows an extremely weak tunnel current to the storage node to accumulate charges, it takes an extremely long time to write. Moreover, repeated writing results in forced flowing of currents through the insulating layer, which accordingly is gradually deteriorated and eventually turns into an conducting layer and becomes unable to store information. It is therefore usual to limit the times of writing to 100,000 for a commercial product. Thus, a flush memory cannot be used as a RAM. Thus, though a DRAM and a flush memory are both large capacity memories, each has its own strengths and weaknesses, and therefore they have to be differentiated in use to take advantage of their respective favorable features.

[Problems to be Solved by the Invention]

An object of the present invention is to provide a small memory cell capable of RAM operation and having a gain and a semiconductor memory apparatus using such cells. A further object is to provide a nonvolatile RAM capable of warranting a holding time of about 10 years with its memory cell structure free from a pn junction current in its storage (memory) node.

[Means for Solving the Problems]

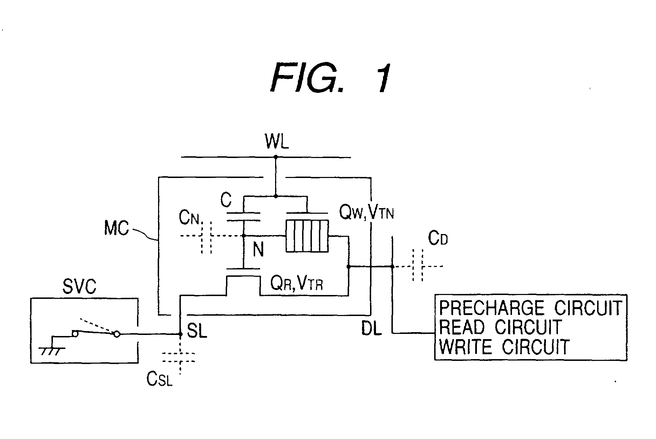

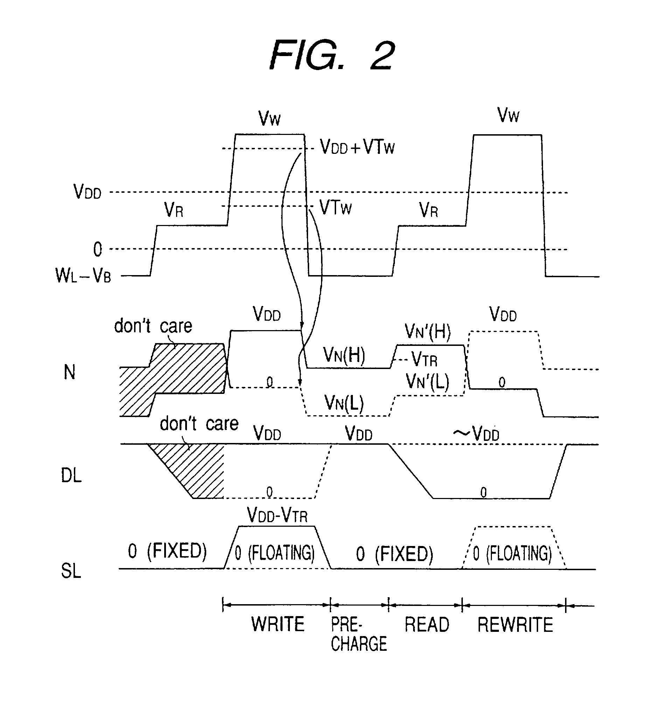

In order to achieve the above-stated objects, a memory cell is configured of two transistors and one capacitor as is shown, for instance, in the circuit diagram of the memory cell of a first embodiment and its operational timing illustrated in Fig. 1 and Fig. 2. Thus the memory cell consists of a read transistor QR, a write transistor QW and a coupling capacitor c for controlling the voltage of a memory cell node N. One end of the electrode of C and the gate of QW are connected to a word line WL, and one end each of QR and QW is connected to a data line. Here, QR is supposed to be, for example, an N channel MOSFET (hereinafter MOS transistor). Also, QW may be composed of an MOSFET, but a transistor utilizing a tunnel phenomenon (hereinafter tunnel transistor) as will be described later may as well be used. In the case of a tunnel transistor, terminal names will be defined in the same way as for the MOSFET for the convenience of explanation. Thus, the terminal connected to the node N will be called the source (or the drain), the terminal connected to the data line DL, the drain (or the source), and the terminal connected to the word line WL, the gate. In this memory cell, because of the presence of the capacitor C, the voltage of the memory node N can be varied according to the word line voltage. Therefore, without having to take the trouble of providing another transistor for selection, the memory cell can be selected, and accordingly a small memory cell can be realized. Especially as will be described below, if a longitudinal or vertical transistor is used as QW and C and/or QR is structured three-dimensionally, the advantage of size reduction will be even more effective. As will be described below, it would be possible to fabricate a memory cell whose area is about half and whose surface is less rugged than a known DRAM cell comprising one MOSFET and one capacitor in a smaller number of masks. Therefore, the memory chip will become easier to fabricate and less costly. Furthermore, if QW is a tunnel transistor, the memory node in the memory cell will have a structure surrounded by an insulating layer, and accordingly there will be no problem of a leak current attributable to a pn junction current or soft errors as a matter of principle unlike in the case of a DRAM cell. Therefore, as the current flowing from the memory node to the data line through QW (the so-called sub-threshold current of MOSFET) when the memory cell is not selected can be suppressed to a sufficiently low level by setting the threshold voltage (VTW) high enough, the data retention time is extended. Therefore, DRAM operations with an extremely long refreshing time or nonvolatile operations needing virtually no refreshing are made possible.

[Preferred Embodiments]

Embodiments of the present invention will be described below with reference to drawings. Incidentally, in the specification of the present application, N denotes the memory node of the memory cell; WL, the word line; and DL, the data line. To the word line WL is inputted a word voltage pulse of a ternary level. Thus, a negative voltage -VB is applied at the time of non-selection, VR at the time of reading, and VW at the time or writing or rewriting. Reading is done with the write transistor QW kept non-conducting. Therefore, the read voltage VR is selected to be a smaller value than the threshold voltage VTW of QW (the gate voltage with reference to the source voltage when QW begins to conduct). And the write voltage VW is selected to be not smaller than VDD + VTW. This is to write into the cell node N a write voltage (VDD or 0 V) matching binary information (1 or 0) without affeet of VTW. The coupling capacitor C performs the role of shifting the voltage (VDD or 0 V) written in the node N toward the negative side, when the write operation has been completed and a shift to the state of non-selection is to be accomplished by altering the word voltage from VW to -VB. It is with a view to increase the voltage amplitude of the word voltage and thereby to shift the voltage of the node N more greatly to the negative side that the word voltage in the state of non-selection is set here to -VB, a negative value. If this voltage of the node N shifted to the negative side is set smaller than the threshold voltage VTR of QR, QR of the non-selected cell will be non-conducting. Of course, QW will also be non-conducting because the gate voltage of QW is -VB. Therefore, even if another memory cell connected to the same data line DL is selected and that data line takes on any voltage between VDD and 0 V, none of unselected cells will adversely affect the selected cell because QR of every one of the plurality of unselected cells is non-conducting. A source voltage control circuit SVC here is a circuit to control the voltage of the source line SL of QR according to read operation and write (or rewrite) operation.

The conducting state of QR is controlled by fixing SL at 0 V at the time of reading and by releasing or feeding an appropriate positive voltage to SL at the time of writing. This makes it possible to solve the following problems which arise at the time of writing (or rewriting) involving the application of the high voltage VDD from the data line DL to the node N. Suppose, for instance, a case in which SL is fixed at 0 V. When the D.C. voltage of VDD is to be applied from the data line to the node N, the read transistor QR is conducting, and the continuous flow of the conducting current results in increased power consumption. Or in the case of rewriting to apply a floating voltage VDD held by the data line to the node, the resultant conducting state of QR causes discharging from the data line and the node N until a drop to about the level of VTR, where the discharging stops. As this reduced voltage is written into the node N, the voltage margin on the high voltage side of the memory cell significantly drops. These problems are solved by, for instance, bringing SL into a release state (a floating voltage of 0 V) at the time of writing. In this case, too, QR becomes conducting and begins to charge SL, but if the incidental capacity CSL of SL is negligibly small relative to the incidental capacity CD of the data line, the SL voltage will be rapidly charged to VDD-VTR to make QR non-conducting. The voltage of the data line, because CSL « CD, will remain substantially at the VDD level, and this voltage will be written as it is into the node N. Therefore, there will be neither continuous flow of a current through QR or nor narrowing of the voltage margin on the high voltage side of the memory cell as referred to above.

The write, hold and read operations will be described in further detail below with reference to Fig. 1.

It is supposed that, in a state in which no memory whatsoever is selected, a precharging circuit places the data line in a floating VDD state as in a DRAM. In other words, it is precharged to VDD. It is further supposed that the source line SL, at the time of writing or rewriting, turns into a floating 0 V state from the previous fixed 0 V voltage, and that CSL is far smaller than CD.

(1) Write operation

An information voltage (VDD or 0) written into the cell node N, in the process of the descent of the word voltage to -VB, the voltage in the off state, is affected by capacitance coupling from the cell capacitor C, becomes the final voltage. Here, VN(H) and VN(L) are supposed to be the final voltages of the node N when the high voltage VDD and the low voltage 0 V, respectively, have been written in. Therefore, this VN(H) or VN(L) becomes the node voltage of the unselected cell. Here, VN(H) is figured out as stated below. Thus, until VW falls to VDD + VTW, the node N is charged from the data line by QW, which is still conducting, even if an attempt is made to lower it with capacitance coupling from C, and therefore is held at VDD after all. During its descent from VDD + VTW to -VB, QW is non-conducting, and accordingly the node N drops at a capacitance coupling ratio $\alpha$. Therefore:

$$VN(H) = VDD - \alpha(VDD + VTW + + VB) \quad \alpha = C/(C + CN) \tag{1}$$

where CN is the incidental capacity of the node N. VN(L) is figured out similarly. In this case, as QW is conducting until VW drops to VTW, the node N is held at 0 V for the above-stated reason. After that, however, it is brought down by capacity coupling, and the following holds:

$$VN(L) = -\alpha(VTW + VB) \tag{2}$$

Expressions (1) and (2) represent cell node (N) voltages in the state of non-selection.

(2) Hold operation

Unselected cells should hold data in any state and should not adversely affect the operation of the selected cell. Even where all the cells are unselected as in the precharging period shown in Fig. 1, or where one of a plurality of cells connected to one data line is selected and the voltage on that data line is varying from 0 to VDD, this condition should be met. This condition can be met if QW and QR are completely non-conducting. Evidently in an unselected cell, QW is completely non-conducting because the threshold voltage of QW (VTW) is sufficiently high, and moreover a negative voltage is applied to its gate. On the other hand, since the SL voltage of an unselected cell is a fixed 0 V, in order for QR to be non-conducting all the time, both of the voltages represented by Expressions (1) and (2), i.e. VN(H) and VN(L), should be lower than the threshold (VTR) of QR. Since VN(H) is always higher than VN(L), this condition can be represented by the following equation.

$$VN(H) = VDD - \alpha(VDD + VTW + VB) < VTR \tag{3}$$

(3) Read operation

When data are read out of a cell, the cell node N is raised in voltage by the applied word voltage VR and the coupling capacitance C, and VN(H) and VN(L) are respectively raised to the voltages VN(H) and VN(L) expressed below.

$$VN(H) = VN(H) + \alpha(VR + VB) = VDD - \alpha(VDD + VTW - VR)$$

$$VN(L) = VN(L) + \alpha(VR + VB) = \alpha(VR - VTW)$$

If, for instance, information "1" and information "0" are to be distinguished from each other here, QR should be conducting at VN(H) and non-conducting at VN(L). As a result of this, the data line precharged to VDD either discharges to 0 V as illustrated or holds VDD. At this time, it is necessary to make the write transistor QW non-conducting to prevent the read operation from being adversely affected by QW. For this purpose, the condition which makes QW non-conducting at VN(L) should be met because QE has a lower source voltage and more readily becomes conducting at VN(L) than at VN(H). Therefore:

$$VN(H) = VDD - \alpha(VDD + VTW - VR) > VTR \tag{4}$$

$$VN(L) = \alpha(VR - VTW) < VTR \tag{5}$$

$$VR - VN(L) < VTW \tag{6}$$

From Expressions (5) and (6):

$$VR < VTW \qquad (7)$$

If the VTR is a positive value, as long as Expression (7) is met, Expression (5) will hold. Therefore the voltage margins of memory cells are determined by Expressions (3), (4) and (7).

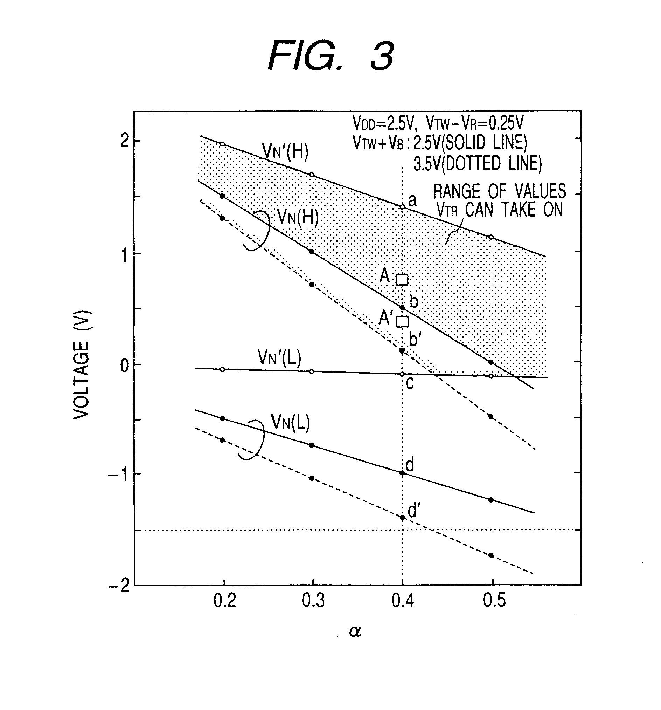

Fig.3 shows the voltages VN(H) and VN(L) of the memory nodes of unselected cells and the voltages VN(H) and VN(L) of the memory node N of the selected cell at the time of reading, figured out with respect to $\alpha$. The voltage condition is that VTW + VB is variable when VDD = 2.5 V and VTW - VR = 0.25 V. The solid line represents VTW + VB = 2.5 V, and the dotted line, VTW + VB = 3.5 V, provided that VN(H) and VN(L), as is evident from Expressions (4) and (5), are constant irrespective of the value of VTW + VB. The range of values VTR can take on are determined by Expressions (3), (4) and (5), represented by the darkened region in the diagram. Here, let's see the relationship between VTR and the voltage margin of the memory cell in the case of $\alpha$ = 0.4 as an example. At VTW = 2 V and VB = 0.5 V, i.e. at VTW + VB = 2.5 V, VTR can take on any value in the range from point a to point b, but suppose VTR = 0.75 V (point A), then, in an unselected cell VN(H) = 0.5 V (point b) and VN(L) = -1 V (point d), therefore the transistor QR is completely non-conducting.

On the other hand, if the cell is selected, VN(H) = 1.4 V (point a), VN(L) = -0.1 V (point c). Therefore, QR becomes conducting at VN(H) and non-conducting at VN(L). The effective gate voltage of QR when it is conducting is VN(H) - VTR = 0.65 V. If the word voltage here is further biased toward the negative side by 1 V to VTW = 2 V and VB = 1.5 V to make VTW + VB = 3.5 V, the effective gate voltage of QR will become even greater to achieve high speed operation. The range of values VTR can take on in this case is extended to between point a and point b, so that VTR can be lowered to 0.35 V (point A') while keeping the voltage margins (the differences between point A and point b and between point A' and point b') in the non-conducting case substantially the same. Therefore the effective gate voltage of QR is increased to VN(H) - VTR = 1.05 V.

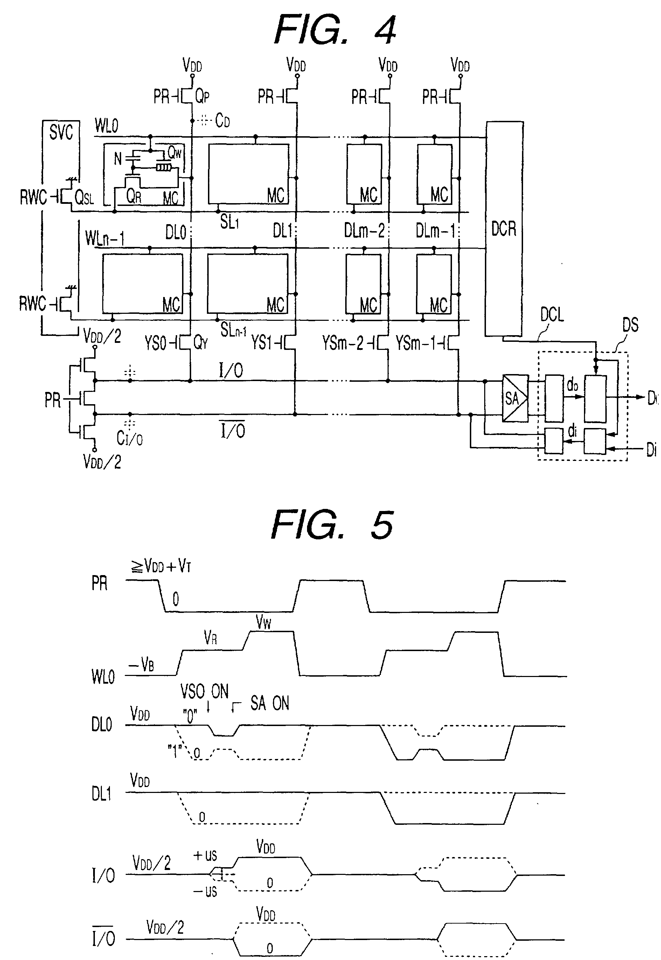

Fig. 4 is a schematic diagram of a memory cell array and its peripheral circuits, and Fig. 5, their timing chart. A memory cell MC is connected to intersections between a plurality of word lines (WL0, ..., WLn - 1) and a plurality of data lines (DL0, ..., DLm - 1). Each data line is selected according to row signals (YS0, YSm - 1) activated by known address signals, and connected to common data input/output paired wires (I/O, I/O) via a row selecting transistor (QY).

The I/O paired wires are connected to a data output Do via a sense amplifier SA and a data I/O buffer DB, and to a data input Di via DB. To each word line is connected a data control register (DCR) for detecting the selection state of the word line, and DB is controlled with a signal from its output signal line (DCL).

Features of this embodiment are as described below. As there is a gain in the memory cell, i.e. the current continuously flowing to the read transistor QR is converted into a voltage on the data line, the signal voltage emerging on the data line becomes extremely high. As stated above, it can be turned into the amplitude of the source voltage depending on the design. Further, the number of memory cells that can be connected to one data line is unlimited as a matter of principle. As there is a gain even if the incidental capacity (CD) of the data line increases, the memory cell will operate properly. As opposed to this, since any known DRAM cell has no gain, the signal voltage emerging on the data line is extremely small. For this reason, it is necessary to take the trouble of arranging paired wires to make the data line suitable for noise suppression, and provide a large area differential CMOS sense amplifier for each data wire pair of a narrow pitch to amplify signals. Furthermore, to reduce CD and enhance the signal voltage, multiple division of data wire pairs and equipment of each divided data wire pair with the aforementioned differential amplifier. All these become a factor to enlarge the chip area. Therefore, this embodiment provides the advantage over any DRAM of stabilizing the operation and making possible reduction of the chip area. The operation of this embodiment will be described below.

When the memory cell array is inactive, the precharging transistor QP on each data line is kept conducting, and every data line is precharged to VDD. The paired I/O wires are also precharged to their half voltage VDD/2 and equalized in potential. Further the control signal RWC for each source line (SL0, SLn-1) is raised to a high level, the transistor QSL on each source line is made conducting, and each source line is fixed at 0 V. When the memory cell array is activated, one word line (e.g. WL0) designated by a line address signal is selected, and a VR voltage is applied to start read operation. This causes reading out of every memory cell on WL0, and a read signal voltage emerges on each corresponding data line. If, for instance, thecell node is VN(H), QR will become conducting, and accordingly DL0, which has been in a floating state of VDD, will be discharged to 0 V. On the other hand, if it is VN(L), QR will be non-conducting, and accordingly DL0 will remain at VDD. When a row address signal causes a row selecting switch (e.g. QY) to be made conducting after the voltage on the data line that has been read out is fixed to either VDD or 0 V, the voltage on DL0 will be taken out onto the I/O line by charge sharing between DL0 and I/O. If DL0 is VDD, a +us signal voltage will emerge on the I/O line for VDD/2, or if it is 0 V, a -us signal voltage will appear.

The incidental capacities of DL0 and I/O being represented here by CD and CI/O, respectively:

$$us = (CD/(CD + CI/O)) \cdot (VDD/2) \tag{8}$$

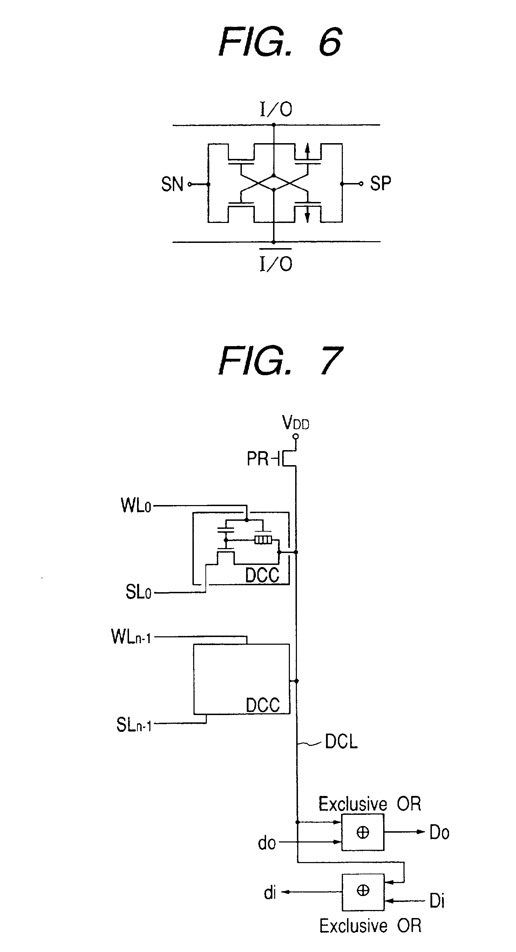

Since the voltage on the other I/O of the paired I/O wires remains VDD/2, if the sense amplifier SA is operated with this voltage as the reference voltage, information on the read voltage can be distinguished. Fig. 6 illustrates a latch type CMOS sense amplifier. If SP and SN which are common terminals of P channel and N channel MOSFETs are driven from VDD/2 to VDD and from VDD/2 to 0 V, respectively, +us information and -us information of the I/O will be amplified to VDD or 0 V, and taken out to the data output terminal Do via the data I/O buffer DB. In parallel with this, the amplified voltage of the I/O is rewritten as it is into the memory cell node N by the application of the vw word voltage following VR. The reason is that, as the voltage of VDD or 0 V read out to DL0 is deteriorated to below VDD or above 0 V by connection to the I/O, it has to be regenerated by the sense amplifier to VDD or 0 V and rewritten. Since other data lines (DL1 to DLm-1) are free from the aforementioned voltage deterioration as a matter of principle, the read-out data line voltage is rewritten as it is into the corresponding memory cell. Hereupon, as described above, immediately before VW is applied, the control signal RWC is set to 0 V and each QSL is turned off to keep each SL line in a floating 0 V state. This prevents, for instance, the voltage level on the data line from dropping at the time of rewriting. Whereas the read operation has been described so far, the write operation is accomplished by utilizing the period of the above-stated rewriting. Thus, a voltage corresponding to write data from the data input terminal Di is provided to the paired I/O wires via the data I/O buffer DB in the form of a differential voltage, and the sense amplifier-amplified voltage is replaced with this voltage. The resultant (VDD or 0 V) can be given from the I/O to the cell node via DL0. Since the memory cell here is a sort of inverter, every time a word line is selected, the node voltages of all the memory cells on that word line are switched between high and low as shown in Fig. 5. Then, in order to ensure that the I/O relationship of data be free from logical inconsistency, the data I/O buffer DB is controlled with the output signal of a data control register (DCR) connected to each word line.

Fig. 7 illustrates a control system for the data control register and the data I/O buffer. The concept of this control system is already described in the Digest, pp. 12-13, of ISSCC72 (International Solid-State Circuits Conference in 1972), citing an example of a DRAM using cells consisting of three transistors each. Thus, to each word line is connected a data control cell (DCC) having the same structure as the memory cell. When a word line is selected, its read signal is outputted from the selected data control cell to a common output signal line (DCL). This signal and a signal read out of a memory cell array via a sense amplifier undergo exclusive-OR operation to give a data output DO. On the other hand, a read signal to DCL and a data input Di undergo exclusive-OR operation to give write data to the memory cell array. Incidentally, for high speed control of data input and output, the channel width of an output transistor (corresponding to QR) in the data control cell can be made greater than the channel width of the memory cell.

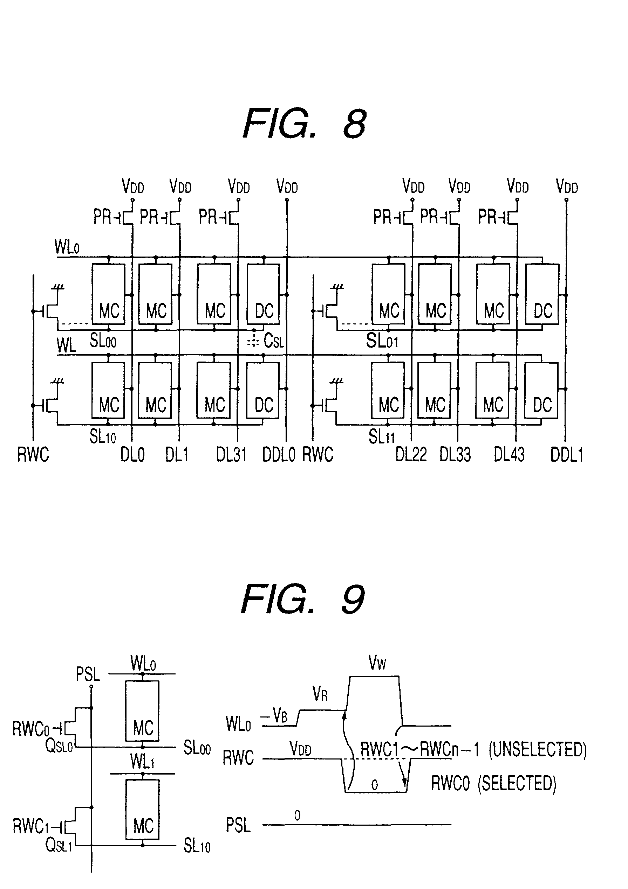

Fig. 8 illustrates a voltage control system for SL lines to prevent the high level (VDD) side of the data line from dropping at the time of rewriting or writing. A feature of this system is that each SL line is multi-divided into SL00, SL01 and so on to reduce the effective incidental capacity (CSL) per SL line. As stated above, when RWC is turned off to place each SL line in a floating state, the aforementioned voltage level drop can be suppressed as much as CSL is reduced relative to the data line incidental capacity (CD). Another feature is that, a dummy cell (DC) of the same structure as the memory cell is connected to each of the divided segment of the SL line to control the voltage of that segment, and its data lines (DDL0, DDL1 and so on) are fixed at VDD all the time. This enables the maximum drop of the aforementioned voltage levels of the data lines to be halved as will be described below. As stated above, a read voltage (VR) is applied to a word line (WL0), and data are read out of every memory cell (MC) on WL0, the read voltage being outputted to each corresponding data line. During this period, of course, SL00, SL01 and so on are fixed at 0 V. After each data line has been sufficiently discharged, SL00, SL01 and so on are placed in a floating state of 0 V, followed by the application of a write voltage (VW) to WL0, and the voltage on each data line is rewritten into the memory node (N) of each memory cell. The extent of the drop on the high level side of the data line here depends on the number of memory cells having specific read information. Thus, the greater the number (k) of the memory cells on which the data line voltage rises to a high level after reading, the less the drop on the high level side, because QR of more memory cells charges the incidental capacities of SL00 and the like to almost VDD-VTR. Thus, with the voltage drop on a data line being represented by AVD, CSL·(VDD - VTR)= kCD · $\Delta$VD holds. Therefore when k = 1, $\Delta$VD takes on the greatest value. What halves this drop is the aforementioned dummy cell (DC). QR in the dummy cell always becomes conducting at the time of rewriting or writing, effectively resulting in k = 2 to halve $\Delta$VD. Besides the dummy cell system, as will be described later, there is a method to apply VW after fixing the SL line at a certain voltage (e.g. VDD-VTR or above). Thus after reading out has resulted in the outputting of a sufficient read voltage to the data line, the SL line is charged from the previous 0 V to VDD-VTR or above, and then VW is applied. Though the cycle time is extended as much as the charging time, there will be no voltage drop on the data line.

Fig. 9 illustrates an embodiment of a circuit for controlling the voltage on the SL line. After reading takes place and the data line voltage is fixed, the gate voltages of transistors QSL0, QSL1 and so on connected to the ends of SL lines are decoded with an address signal and individually controlled. For this reason, only the QSL0 corresponding to the selected word line (WL0) becomes non-conducting, only QL00 takes on a floating state of 0 V. Since other transistors in the state of non-selection remain conducting, SL10 and others are fixed at 0 V. After that, a word voltage VW is applied. Higher speed is achieved because the load capacity of RWC is reduced compared with the case of Fig. 8, wherein RWC collectively controls the gates of a plurality of transistors.

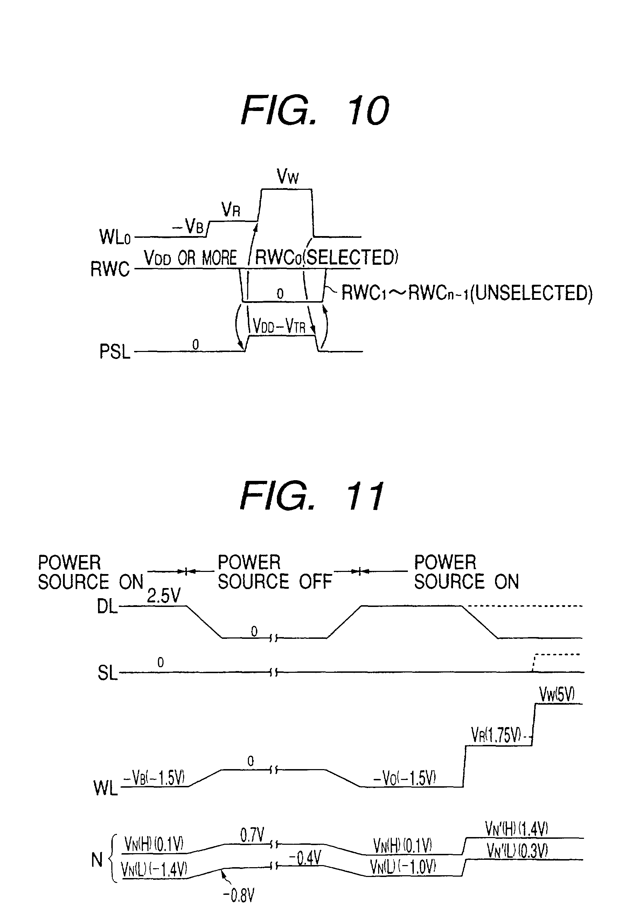

Fig. 10 shows an example of pulse drive without fixing the voltage supply source PSL for the SL line at 0 V all the time as in Fig. 9. This results in forced drive of SL00 to VDD-VTR at the time VW is applied. The gate voltages of QSL0, QSL1 and so on are decoded with an address signal, and only the selected transistor (QSL0) becomes conducting with the result that SL00 is substantially the only load capacity of PSL and higher speed is achieved.

Although the foregoing description assumed that charging of the SL line to VDD-VTR would make QR non-conducting, actually QR becomes non-conducting at a considerably lower voltage than VDD-VTR, because, as is well known, VTR is raised by the body effect of QR as the SL line is charged. Therefore, ΔVD is actually smaller, and the charge voltage of the SL line may be lower.

If a tunnel transistor to be described later is used here as the write transistor (QW) in the memory cell, a structure in which the memory node is surrounded by an insulating layer will be made possible, enabling nonvolatile operation to be conducted. Since no pn junction current is present in the memory node, the charge of the memory node will be lost by as much as the route passing QW, because, if the threshold voltage of QW (VTW) is set high enough, around 2 V, the current passing QW will become negligibly small. This will be described below with reference to the example of Fig. 3 in which VTW + VB = 3.5 V, VTW = 2 V, and $\alpha$ = 0.4.

As illustrated in Fig. 11, if the source voltage is intercepted (turned off), word lines and data lines will eventually take on a floating state of 0 V. Then, the voltages stored in the memory node (points b' and d' in Fig. 3) are raised by the capacitor C of the memory cell. As the variation of the word voltage is $\alpha$ = 0.4 at 1.5 V, VN(H) will rise by 0.6 V to reach 0.7 V. On the other hand, N(L) will also rise to -0.8 V. During the ensuing period in which the power source is off (e.g. for a maximum of 10 years), QW is weakly conducting and the memory node N is charged from the data line. Here it is supposed that the minimum threshold voltage of QW, at which QW completely turns off, is 1.6 V as will be discussed in detail below. As the word voltage is VTW = 2 V at 0 V, only the -0.8 V side, which poses a problem among the aforesaid node voltages, is charged, and charging stops when 0.4 V is reached. When the power source is turned on again, the memory node is brought down by 0.6 V by a variation in word voltage and by the capacitor. After that, a voltage (VR) is applied to a word line to start read operation. The memory node voltage then is raised by only 1.3 V, resulting in VN(H) = 1.4 V and VN(L) = 0.3 V. The evident turning-off of the power source reduces the voltage difference between VN(H) and VN(L) from 1.5 V to 1.1 V. However, if the threshold voltage (VTR) of QR is selected to be 0.75 V, QR will become conducting at VN(H) and non-conducting at VN(L), and the memory cell will operate properly. Thus, nonvolatile operation will be realized. Of course, the voltage difference between VN(H) and VN(L) in the second and subsequent rounds of read operation after the power source is turned on will return to 1.5 V.

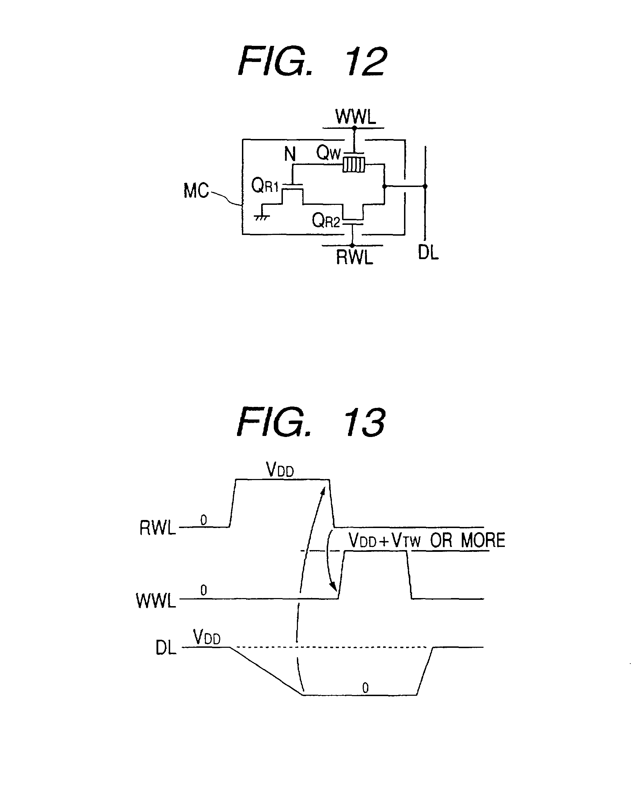

Fig. 12 and Fig. 13 illustrate another embodiment of a memory cell and its operational timing. The capacitor (C) is eliminated from the memory cell of Fig. 1, and a read selecting MOSFET (QR2) is added. The memory cell area is greater than that of Fig. 1, but the design is simplified. Thus:

(1) A read only word line (RWL) is turned on to output memory information in the node N to the data line DL. If the voltage of the node N is at a high level (VDD), both QR1 and QR2 will become conducting, and therefore the data line (DL) so far precharged to the VDD level will discharge to 0 V. If the voltage of the node N is at a low level (0 V), QR1 will be non-conducting, and therefore the data line will remain at VDD. After the voltage of the data line is made definitive by this read operation, RWL is turned off, and after that a write only word line (WWL) is turned on. Read information is thereby rewritten onto the data line. Or writing into a specific memory cell on the same word line is accomplished by forcibly providing a write data voltage from outside. Therefore, unlike in Fig. 1, memory cells will not always dynamically operate, having a continuous flow of a through current. Accordingly, there is no need for the above-mentioned capacitor (C) or voltage control of SL lines, and the voltage on SL lines may be a fixed voltage (0 V).

(2) As WWL is off while RWL is on, there is no fear for memory information in memory cells to be destroyed by read operation.

(3) Any negative voltage need not be applied to word lines (RWL and WWL) at the time of non-selection unless the threshold voltage of QR2 or QW particularly drops. Of course, if the aforementioned threshold voltage is too low, the two transistors should be made non-conducting by feeding a negative voltage.

(4) There is no need for the voltage to be fed to word lines to have a ternary level as shown in Fig. 2.

If a tunnel transistor is used as QW here, the memory cells can be reduced in size because, as will be described later, QW and QR1 can be three-dimensionally structured. If the coupling capacitance between WWL and the memory node N here is made as small as possible, approximately VDD and 0 V are written into the memory node and held. The electric charge of the node N is also held for a long period, and if the threshold voltage of QW is set sufficiently high, the aforementioned nonvolatile operation can be realized more easily. Of course, a memory cell array using such memory cells can be configured in the circuitry illustrated in Fig. 4. The configuration would be exactly the same except that there would be two word lines, RWL and WWL, and SL lines would be fixed to the ground voltage.

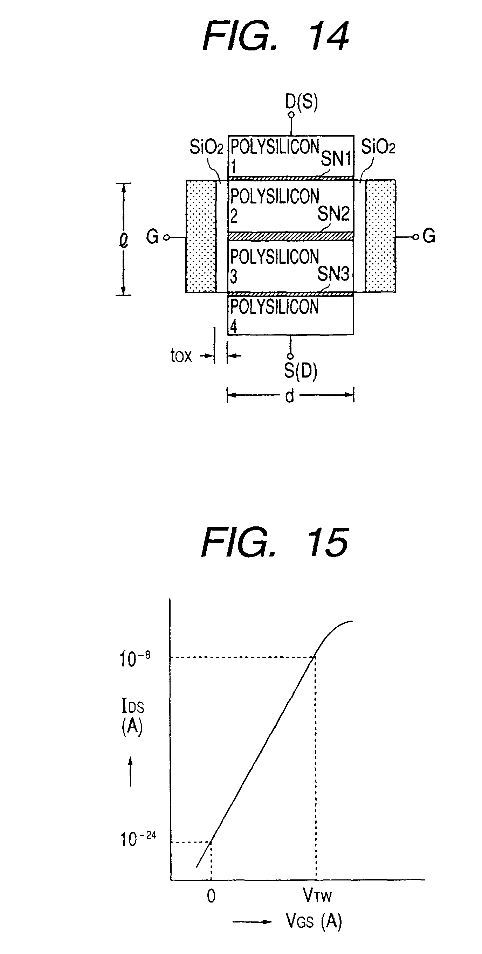

Fig. 14 is a schematic diagram of a cross-sectional structure of a tunnel transistor. A feature consists in that it is a longitudinal transistor in which gate electrodes G are arranged on two sides of four stacked polysilicon layers (polysilicon 1 to polysilicon 4) via a gate oxide film (a thermal oxide film of tox in thickness). Actually the gate electrodes formed of polysilicon on the two sides are formed solid as will be described below and always equal in potential. Polysilicon 1 and polysilicon 2 are made of polysilicon doped with phosphorus of about $10^{20}$cm$^{-3}$, and constitute the drain D (or the source S) and the source (or the drain) of the transistor. Polysilicon 2 and polysilicon 3 are made of intrinsic polysilicon doped with an extremely low concentration (about $10^{15}$ to $10^{17}$ cm$^{-3}$) of phosphorus, and constitute the substrate of the transistor. Between polysilicon 1 and polysilicon 2, between polysilicon 2 and polysilicon 3, and between polysilicon 3 and polysilicon 4 are formed tunnel films SN1, SN2 and SN3, each consisting of a thin (2 to 3 nm) silicon nitride film for instance. SN1 and SN3 are assigned the role of stoppers to prevent, at the time of transistor formation, phosphorus of a high concentration in the drain or source region from diffusing into the low concentration layers inside (polysilicon 2 and polysilicon 3). To let a current flow between the drain and the source, these films should be tunnel films not too thick. The central tunnel film SN2 is intended to suppress the "off" current of the transistor. Thus, it is a stopper to prevent positive holes or electrons generating in the region of polysilicon 2 and polysilicon 3 in the transistor in an "off" state from becoming a current and flowing between the drain and the source. Incidentally, if a sufficiently high positive voltage is applied to the gate, the potential barrier of this tunnel film will lower, and allow a sufficient large "on" current to flow between the drain and the source. Of course, depending on the target amperage of the "off" current, this central tunnel film can be dispensed with. Further, although a single central film layer is supposed to be provided, it may be a tunnel film consisting of multiple layers as required. Typical approximate dimensions of the tunnel transistor of Fig. 14 are 1 = 0.4 μm, d = 0.2 μm and tox = 10 nm. This kind of transistor, if an appropriate tunnel film thickness is chosen, can achieve amperage/voltage characteristics similar to those of a conventional transverse MOS transistor of an extremely low substrate concentration. Fig. 15 roughly shows its characteristics. The maximum tolerable amperage (i) of the current flowing between the drain and the source (IDS) to warrant nonvolatility for 10 years is now figured out. The capacity (C) of the memory node (N) being supposed to be 5 fF and the tolerable voltage drop (ΔV) for 10 years (At) to be 0.1 v and i = C • ΔV/Δt = 1.6 x $10^{-24}$A. On the other hand, in a usual circuit design, the threshold voltage of a transistor (corresponding to VTW mentioned above) is defined by the gate/source voltage (VGS) for letting a current of IDS = about $10^{-8}$A flow. Since the relationship between IDS and VGS is linear in the current region represent semilogarithmically in the diagram from $10^{-24}$A to $10^{-8}$A, if the value of VGS to increase IDS by one digit is 100 mV, VTW0.1(V/digit) $\times$ 16 (digits) = 1.6 V. This VTW value is the minimum required to keep the transistor (QW) off for about 10 years. In an actual design, the standard VTW is set to 2 V as stated above, with the fluctuations of VTW and temperature characteristics being taken into account.

To add, where it is sufficient for one memory cell to hold data for a duration of one day or so, the maximum amperage tolerance is about $10^{-20}$ A, and therefore VTW 0.1(V/digit)x 12 (digits) = 1.2 V would be sufficient. Considering possible fluctuations as mentioned above, the standard VTW may be set to 1.6 V. Accordingly, the maximum required word voltage (VDD + VTW or more) is smaller by the decrease of VTW than in nonvolatile operation, so that the requirement regarding the breakdown voltage of transistors in peripheral circuits driving the write transistor (QW) and word lines within the memory cell is eased. In this case, incidentally, refreshing action well known for DRAMs would enable data in the memory cell to be held. Thus, it is sufficient to drive word lines and perform the aforementioned read and write operations on each word line sequentially and periodically.

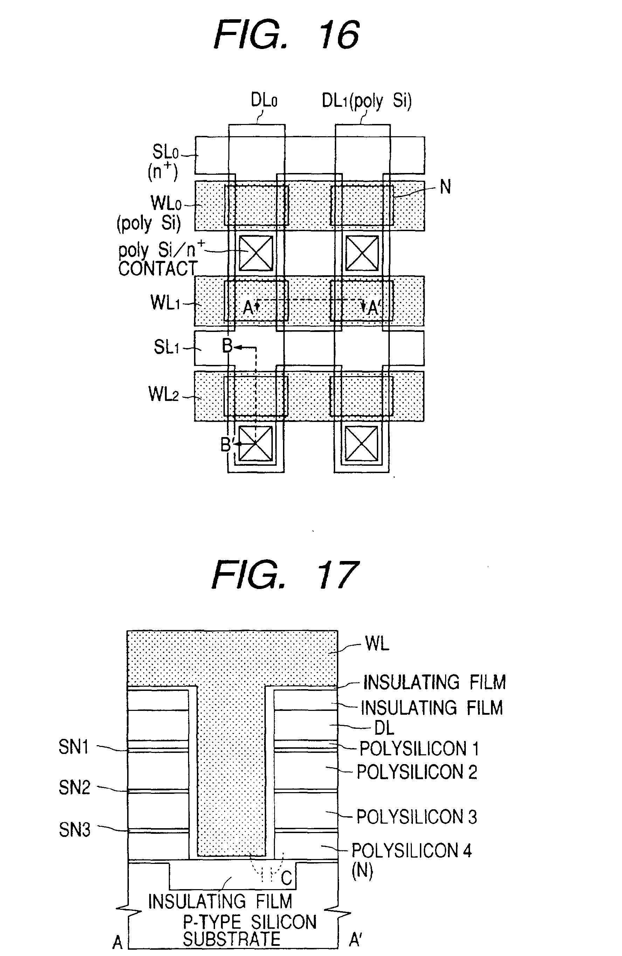

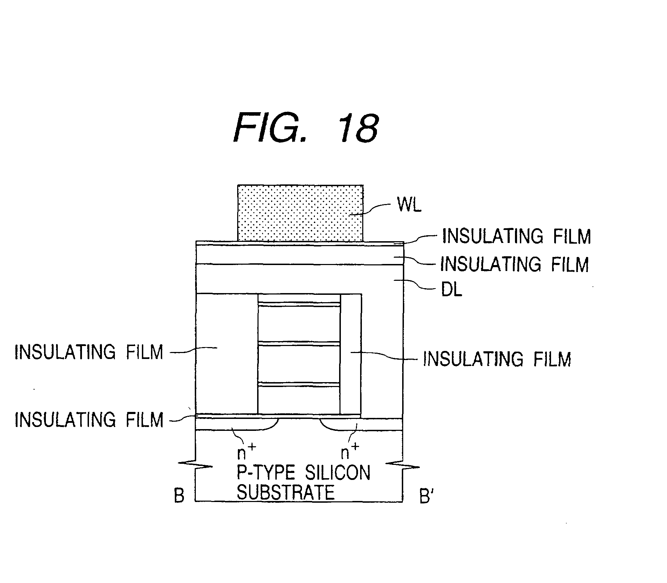

Fig. 16 illustrates the planar structure of the memory cell of Fig. 1. The transistor of Fig. 14 is used as the write transistor. Fig. 17 shows an AA cross section, and Fig. 18, a BB cross section. Over a data line (DL) formed of a phosphorus-doped n type polysilicon film, a word line (WL) formed of a boron-doped P type polysilicon film is orthogonally arranged with a thick insulating layer in-between. As the three-dimensional tunnel transistor of Fig. 14 is stacked over the gate electrode (N) of a usual MOSFET (QR in Fig. 1), a memory cell of an extremely high density can be realized. Evidently, while the current of QR flows within a plane, the current of QW flow in a direction vertical to that. For this reason, while the area of a DRAM memory cell of the well known data line arrangement is 8F2 (F: the smallest dimension) as a matter of principle, that according to the present invention is 4F2, i.e. a halved cell area. To add, the coupling capacitor (C) of Fig. 1 can be formed, as shown in Fig. 17, of a thin thermal oxide film between the word line and polysilicon 4. The size of C can be varied by adjusting the film thickness of polysilicon 4. The memory cell hereunder can have a long enough data holding period and be significantly strong against soft errors due to the incidence of alpha rays or the like, if only the threshold voltage (VTW) of QW is properly set as described above. The reason is that, since the memory cell node (N) has no pn junction, there is no junction leak current, and that, even if the cell is irradiated with alpha rays and electron-hole pairs generate inside, there will be no change in potential within the cell as the tunnel film serves as a stopper against the respective streams of electrons and positive holes.

So far, a circuit system for memory cells intended to reduce the dimensions of memory cells and an operational system for a memory cell array comprising such memory cells have been described. For a further reduction in dimensions, an example of memory cell structure using a three-dimensional transistor, such as a tunnel transistor, was also presented.

[Effects of the Invention]

The above-described invention can make it possible to realize high density, large capacity memories and, moreover, even high speed, nonvolatile memories. Further can be realized a semiconductor apparatus, with such memories and a large scale logic (e.g. a microprocessor) built into a single chip. As is well known, semiconductor chips with conventional DRAMs built into them are becoming increasingly difficult to manufacture as they become finer. Thus in laminated capacitor cells, the cell array is structured with increasingly large disalignments or multi-levels to achieve a high capacitance, and this obstructs large scale logic parts from being made finer. On the other hand, groove type capacitor cells require grooves of an increasingly higher aspect ratio, and therefore become more difficult to fabricate. For instance, the aspect ratio is even 40 in a 256M bit DRAM. By contrast, a memory according to the present invention has a gain within memory cells, and accordingly needs no particularly large capacitance. Therefore, no large disalignment structures and deep groove structures, whose difficulty becomes further significant as chips become finer, are needed, so that a semiconductor apparatus which is easy and inexpensive to make can be provided.

[Brief Description of Drawings]

[Fig. 1]

This is a circuit diagram of a memory cell which is a first embodiment of the present invention.

[Fig. 2]

This is an operational timing chart of the memory cell which is the first embodiment of the invention.

[Fig. 3]

This is a node voltage chart of the memory cell which is the first embodiment of the invention.

[Fig. 4]

This is a circuit diagram of memory cell array according to the invention.

[Fig. 5]

This is an operational timing chart of the memory cell array according to the invention.

[Fig. 6]

This illustrates a CMOS sense amplifier consisting of a PMOS transistor and an NMOS transistor applicable to the invention.

[Fig. 7]

This illustrates a register consisting of a data control cell applicable to the invention.

[Fig. 8]

This illustrates a circuit system for controlling the terminal voltage of the memory cell according to the invention.

[Fig. 9]

This illustrates another circuit system for controlling the terminal voltage of the memory cell according to the invention.

[Fig. 10]

This is an operational timing chart of controlling the terminal voltage of the memory cell according to the invention.

[Fig. 11]

This is an operational timing chart of nonvolatile operations of the memory cell according to the invention.

[Fig. 12]

This is a circuit diagram of a memory cell which is a second embodiment of the invention.

[Fig. 13]

This is an operational timing chart of the memory cell which is the second embodiment of the invention.

[Fig. 14]

This is a schematic cross-sectional view of a tunnel transistor of an embodiment of the invention.

[Fig. 15]

This illustrates current and voltage characteristics to figure out the required threshold voltage of a write transistor in the memory cell.

[Fig. 16]

This is a plan of the memory cell which is the first embodiment of the invention.

[Fig. 17]

This is a cross section of the memory cell which is the first embodiment of the invention.

[Fig. 18]

This is another cross section of the memory cell which is the first embodiment of the invention.

[Explanation of Reference Symbols]

N:     memory node of memory cell
WL:   Word line
DL:    Data line

**Claims**

1.   A semiconductor apparatus having a memory cell comprising an MOS transistor for holding an information voltage at its gate, a write transistor for providing the information voltage, and a capacitor for controlling the voltage of the gate.

2.   A semiconductor apparatus characterized in that, in the memory cell of Claim 1, first and second terminals of the write transistor are respectively connected to the gate and a data line providing write data, a third terminal is connected to a word line, an electrode at one end of the capacitor is connected to the gate, and the electrode voltage at the other end is controlled when the memory cell undergoes reading.

3.   A semiconductor apparatus characterized in that, in the memory cell of Claim 2, the electrode of the other end of the capacitor is connected to the word line.

4.   A semiconductor apparatus characterized in that, in the memory cell of Claims 1 through 3, the drain (or source) of the MOS transistor is connected to the data line.

**5.** A semiconductor apparatus characterized in that, in the memory cell of Claim 4, the drain (or source) of the MOS transistor is controlled so as to take on different voltages at the time of reading out of and at the time of writing or rewriting into the memory cell.

**6.** A semiconductor apparatus characterized in that, in the memory cell of Claim 3, the amplitude of the selecting pulse voltage of the word line at the time of reading out is smaller than the amplitude of the selecting pulse voltage at the time of rewriting or writing.

**7.** A semiconductor apparatus characterized in that, in the memory cell of Claim 5, the sources (or the drains) of a plurality of memory cells connected in the direction of the word line are commonly wired, and cells, having substantially the same structure as those memory cells, for controlling the voltage of the common connecting wires are provided correspondingly to the plurality of memory cells.

**8.** A semiconductor apparatus having a memory cell comprising an MOS transistor for holding an information voltage at its gate and a write transistor for providing the information voltage, characterized in that first and second terminals of the write transistor are respectively connected to the gate and a data line, a third terminal is connected to a word line, and the drain (or source) of the MOS transistor is connected to the data line either directly or via another transistor, wherein the write transistor consists of a structure of a multi-layered semiconductor region and a barrier insulating film, and performs writing and deletion of electric charges or either of them through the barrier insulating film.

**9.** A semiconductor apparatus having an array of memory cells each comprising at least of an MOS transistor for holding an information voltage at its gate and a write transistor for providing the information voltage, and the drain (or source) of the MOS transistor is connected to a data line, wherein the data line is precharged to a high voltage before reading out of the memory cell takes place, the data line discharges to a low voltage if the MOS transistor becomes conducting according to an information voltage at the time of reading or the data line is held at the previous high voltage when the transistor does not become conducting, wherein a sense amplifier on common data lines provided correspondingly to a plurality of data lines operates with reference to an intermediate voltage between the high voltage and the low voltage.

**10.** A semiconductor apparatus of Claim 8, characterized in that the threshold voltage of the write transistor is higher than the threshold voltage of the MOS transistor holding an information voltage at its gate.

**11.** A semiconductor apparatus having a memory cell conprising at least of an MOS transistor for holding an information voltage at its gate and a write transistor for providing the information voltage, the memory cell being characterized by the orthogonality of the current paths of the two transistors to each other.

**12.** A semiconductor apparatus having a memory cell characterized in that the write transistor comprises a barrier insulating layer structure, controls an information voltage by writing and deleting electric charges via the barrier insulating layer, and is arranged three-dimensionally relative to the MOS transistor. [Detailed Description of the Invention]

# FIG. 1

# FIG. 2

EP 1 120 791 A1

FIG. 3

$V_{DD}$=2.5V, $V_{TW}-V_R$=0.25V
$V_{TW}+V_B$ : 2.5V(SOLID LINE)
3.5V(DOTTED LINE)

RANGE OF VALUES $V_{TR}$ CAN TAKE ON

$V_N'(H)$

$V_N(H)$

$V_N'(L)$

$V_N(L)$

VOLTAGE (V)

$\alpha$

# FIG. 4

# FIG. 5

# FIG. 6

# FIG. 7

## FIG. 8

## FIG. 9

# FIG. 10

WLo — $-V_B$ / $V_R$ / $V_W$

RWC — VDD OR MORE / RWCo(SELECTED)

0 RWC1~RWCn-1(UNSELECTED)

$\left(V_{DD}-V_{TR}\right)$

PSL — 0

# FIG. 11

POWER SOURCE ON ⟷ POWER SOURCE OFF ⟷ POWER SOURCE ON

DL — 2.5V — 0

SL — 0

WL — $-V_B(-1.5V)$ — 0 — $-V_0(-1.5V)$ — $V_R(1.75V)$ / $V_W(5V)$

N { $V_N(H)$ (0.1V) — 0.7V — $V_N(H)$ (0.1V) — $V_N'(H)$ (1.4V)
    $V_N(L)$ (-1.4V) — -0.4V — $V_N(L)$ (-1.0V) — $V_N'(L)$ (0.3V) }

-0.8V

# FIG. 12

# FIG. 13

# FIG. 14

# FIG. 15

# FIG. 16

DL₀     DL₁(poly Si)

SL₀ (n⁺)

WL₀ (poly Si)    N

poly Si/n⁺ CONTACT

WL₁    A    A'

SL₁    B

WL₂

B'

# FIG. 17

WL

INSULATING FILM
INSULATING FILM
DL
POLYSILICON 1
POLYSILICON 2

SN1
SN2
SN3

POLYSILICON 3

POLYSILICON 4 (N)

C

INSULATING FILM
P-TYPE SILICON SUBSTRATE

A    A'

# FIG. 18

WL

INSULATING FILM

INSULATING FILM

DL

INSULATING FILM

INSULATING FILM

INSULATING FILM

$n^+$   $n^+$

P-TYPE SILICON
SUBSTRATE

B          B'

# INTERNATIONAL SEARCH REPORT

| | International application No. |
|---|---|
| | PCT/JP99/05338 |

## A. CLASSIFICATION OF SUBJECT MATTER
Int.Cl⁷   G11C 11/40, 16/04
         H01L 27/108

According to International Patent Classification (IPC) or to both national classification and IPC

## B.   FIELDS SEARCHED

Minimum documentation searched (classification system followed by classification symbols)
Int.Cl⁷   G11C 11/40, H01L 27/108

Documentation searched other than minimum documentation to the extent that such documents are included in the fields searched
Jitsuyo Shinan Koho        1926-1996    Jitsuyo Shinan Toroku Koho  1996-1999
Kokai Jitsuyo Shinan Koho  1971-1999    Toroku Jitsuyo Shinan Koho  1994-1999

Electronic data base consulted during the international search (name of data base and, where practicable, search terms used)

## C.   DOCUMENTS CONSIDERED TO BE RELEVANT

| Category* | Citation of document, with indication, where appropriate, of the relevant passages | Relevant to claim No. |
|---|---|---|
| X<br>A | JP, 10-200001, A (Hitachi, Ltd.),<br>31 July, 1998 (31.07.98),<br>Figs. 20, 27, 28<br>& CN, 1195861, A | 1-3,6,8-12<br>7 |
| X | JP, 2-54572, A (Matsushita Electric Ind. Co., Ltd.),<br>23 February, 1990 (23.02.90),<br>Fig. 1   (Family: none) | 4 |
| X | JP, 63-4671, A (Hitachi, Ltd.),<br>09 January, 1988 (09.01.88),<br>Fig. 3   (Family: none) | 4 |
| X | US, 5798965, A (Young Kwon Jun),<br>25 August, 1998 (25.08.98),<br>Figs. 2, 3; column 8, lines 26 to 37<br>& JP, 9-283725, A<br>(LG Semicon Co., Ltd. ),<br>Figs. 2, 3; Par. No. [0029]<br>& DE, 19705001, A    & KR, 97072409, A | 4,5 |

☐  Further documents are listed in the continuation of Box C.      ☐   See patent family annex.

| | |
|---|---|
| *  Special categories of cited documents:<br>"A"  document defining the general state of the art which is not considered to be of particular relevance<br>"E"  earlier document but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search<br>27 December, 1999 (27.12.99) | Date of mailing of the international search report<br>25 January, 2000 (15.01.00) |
|---|---|
| Name and mailing address of the ISA/<br>Japanese Patent Office | Authorized officer |
| Facsimile No. | Telephone No. |

Form PCT/ISA/210 (second sheet) (July 1992)